# EUROPEAN PATENT SPECIFICATION

(11) **EP 0 905 274 B1**
(45) Date of publication and mention of the grant of the patent: **30.07.2003**
(21) Application number: 96922302.3
(22) Date of filing: 26.04.1996
(51) Int. Cl.: C23C 14/56, H01G 9/045, C23C 14/06, C23C 14/16, H01G 9/058

(54) **METHOD AND DEVICE FOR APPLYING POROUS COATINGS AND CATHODE FILM OF AN ELECTROLYTIC CONDENSER**
VERFAHREN UND VORRICHTUNG ZUM AUFBRINGEN VON PORÖSEN SCHICHTEN UND KATHODENFILM EINES ELEKTROLYTISCHEN KONDENSORS
PROCEDE ET DISPOSITIF DE DEPOSITION DE REVETEMENT POREUX ET FEUILLE CATHODIQUE DE CONDENSATEUR ELECTROLYTIQUE

(30) Priority: 03.04.1996 RU 96106009; 03.04.1996 RU 96106008
(43) Date of publication of application: 31.03.1999
(73) Proprietor: "OKB "TITAN",ZAO, 109147 Moscow (RU)
(72) Inventor: RYAZANTSEV, Sergei Nikolaevich, Khmelnitsky, 280000 (UA); JURKEVICH, Igor Nikolaevich, Khmelnisky, 280000 (UA); KOSHELEVSKY, Viktor Fadeevich, Khmelnitsky, 280016 (UA)
(74) Representative: Kruspig, Volkmar, Dipl.-Ing.
(86) International application number: RU9600104
(87) International publication number: WO97037052

(56) References cited:
- EP-A- 0 272 926
- EP-A- 0 672 762
- WO-A-89/01230
- DD-A- 205 192
- DE-A- 3 210 420
- GB-A- 2 083 840
- SU-A- 364 689
- SU-A- 451 135
- SU-A- 546 026
- PATENT ABSTRACTS OF JAPAN vol. 017, no. 310 (E-1380), 14 June 1993 (1993-06-14) -& JP 05 029180 A (ELNA CO LTD), 5 February 1993 (1993-02-05)
- PATENT ABSTRACTS OF JAPAN vol. 017, no. 192 (E-1350), 14 April 1993 (1993-04-14) & JP 04 340213 A (TORAY IND INC;OTHERS: 01), 26 November 1992 (1992-11-26)
- PATENT ABSTRACTS OF JAPAN vol. 1996, no. 01, 31 January 1996 (1996-01-31) & JP 07 233474 A (ULVAC JAPAN LTD), 5 September 1995 (1995-09-05)

## Description

This invention relates to technology of electrolytic condensers manufacture, in particular, to a cathode film of an aluminium electrolytic condenser, to a method of its manufacture and to devices for applying porous surfaces by vacuum deposition on a strip which is moved continuously, the technology allows to obtain the highly porous metal surface on the aluminium film.

The word "aluminium" shall be interpreted in the description of this invention as the pure aluminium, as well as its alloys, and the word "condenser" shall be interpreted as the aluminium electrolytic condenser.

For reduction of dimensions and weight of condensers it is necessary to increase their specific capacity, and, hence, to increase specific capacity of anode and cathode films. The specific capacity of a condenser is limited by the specific capacity of the anode film. The condition Cₖ > 10 x Cₐ should be satisfied for the condenser and the anode film will not differ in the specific capacity more, than on 10%, where:
Cₖ is the specific capacity of a cathode,
Cₐ is the specific capacity of an anode.

The specific capacity of modern anode films reaches the values of 200-250 µF/cm² at voltage of 6.3. So, the specific capacity of a cathode film should be not less than 2000-2500 mkF/cm² to enable realization of the anode capacity completely. Commercially available cathode films does not satisfy to these requirements.

Basic means of perfection of cathode film specific characteristics are:
- increase of the area of a cathode film surface;
- reduction of losses, arising on a film-electrolyte transition layer due to change of a conductivity mode;
- increase of corrosion resistance properties of a cathode material in the range of condenser working temperatures and corresponding increase of specific capacity stability.

One of these ways is used, as a rule, in the known technical solutions. For example, increase of the cathode specific capacity thanks to increase of the cathode film surface area was disclosed in EPO publication No. 0272926, IPC H01G 9/04, 1987. Increase of the cathode capacity by formation on the film of a dielectric coating with high dielectric permeability, or by reduction of dielectric coating thickness is disclosed in Japanese application No. 3-77651, IPC G 9/04, 1991. JP-A-05 029 180 discloses a cathode for an electrolytic capacitor which comprises an aluminium substrate and a titanium and/or a titanium nitride layer deposited on the substrate.

The known technical solutions provide for condenser cathode film manufacture by the method of vacuum deposition of a titanium layer on an aluminium film (base). The surface of the base, as a rule, was previously wet or dry etched for the working surface increase. Titanium deposition is made in the atmosphere of inert gases. However, the titanium of the coating is oxidized at extraction from a vacuum chamber by the air oxygen with formation of a titanium oxide layer, that results with the time to filing in the pores and to reduction of the specific capacity. Besides, capacity stability is low.

Miniaturization of electrolytic condensers requires improvement of its specific parameters, and first of all increase of the film specific capacity. An effective way of the specific capacity increase is the increase of the film surface area.

USA patent No. 4546725, IPC C23c 13/10, 1985, discloses a device for porous coating deposition on a strip, containing a vaporizer and two rollers made in the form of cylinders and located above the vaporizer in such a way, that a part of the strip between rollers is located under a sharp angle to the vaporizer vertical axis.

The angle of incidence of the vapour stream on the film changes in limits 0-80° in the known device. The angle of condensation being variable, the structure of metal cover on a strip have a fine grain structure with predominantly closed microscopic pores, which become filed in when the cover material is oxidized by the air oxygen outside the chamber. As a result the cover has a small open porosity, i.e. small surface area, that does not permit to use it as the cathode or anode of electrolytic condensers.

A device for applying porous surfaces, which is disclosed in DDR patent DD 205,192, IPC C23c 13/10, 1983, may be considered as the nearest to this invention by its technical essence. It contains a vaporizer, guide and deflecting rollers which are manufactured in the form of cooled cylinders and located above the vaporizer in such a way that the strip bending around the rollers forms a polygonal line having sections (sites of applying) between the directing rollers.

The known device permits to receive a porous coating on the strip, however the inclined condensation of a vaporized material on the strip does not provide a strong bond between the coating and the substrata, as well as between particles in the coating, because of influence of such factors as the air, impurities and pollution adsorbed on the strip, the shadow effect, temperature insufficient for thermal activation, and so on. These factors are typical for a coating deposition on a substrata under the sharp angle. They reduce processes of activation and chemical interaction which are necessary for obtaining the strong chemical bonds between atoms. Besides, the cold strip gets into the high temperature zone in sections between the lower guide rollers, where its intensive heating occurs. Thus free linear temperature expansion of the strip along the guide rollers is prevented by significant forces of friction between the strip and the rollers. The force of friction is determined by the contact area of the rollers and the strip, by increased friction factor in the vacuum and by film tension at rewinding. As a result, the strip rigidity is not enough for self-flattening (it is advisable economically to manufacture condenser film from aluminium film of thickness less than 50 µm and width not less than 200 mm), and creases are formed on the strip.

Thus the known technical solutions have common disadvantages:
- the low porosity, and
- the creases formation on the strip.

This invention eliminates afore mentioned disadvantages.

The following problems form an invention basis:
- application of porous coating on a strip, wherein a change of the trajectory of the strip movement above a vaporizer would allow to receive a columnar structure in the coating with maximum opened porosity and with good adhesion of porous coating with the strip;
- prevention of creases formation on the strip having the width more than 150 mm.

A technical result of this invention is the manufacture of columnar structure coating with maximally opened porosity, good adhesion of porous coating with the strip and prevention of creases formation.

At manufacture of condenser films by deposition the rectifying metals porous coating on both sides of the film, the maximum coating surface area can be achieved by formation on the film of columnar structure having maximally opened porosity. The columnar structure coating of elongated crystalline grains and of crystalline blocks (dendrites), separated by pores in the form of branched channels network with predominantly opened outward exits, can be manufactured on an aluminium film, if certain process parameters will be observed. There is, first of all, the condensation temperature which should be within the limits of 0.25-0.50 of the vaporized material melting point, and the angle of incidence of a vapour stream on a film (the angle between the straight line, connecting the vaporizer centre with any point on the film, and the normal to the film in this point), which should make 50±10°.

Therefore additional technical result of this invention is the manufacture of a cathode film with the most developed possible surface, high corrosion resistance in electrolytes and low electrical resistance at the cathode-electrolyte junction.

The technical result is reached at manufacture of an electrolytic condenser cathode film, containing:
- a porous titanium layer on an aluminium film surface (a base), including crystalline grains and crystalline blocks (dendrites) of average height not more than 2 µm with bulges and hollows surrounded by pores in the form of branched channels network with predominantly opened outward exits;
- a titanium nitride layer in the form of leaky aggregated grains with bulges and hollows on their surface.

Thus the thickness of the titanium porous layer on the aluminium film surface makes, on the average, 0.5-5.0 µm, the total porosity - 25-50 %, and the bulges and hollows on the crystalline grains and crystalline blocks of the titanium porous layer have height, on the average, of 0.01-1.00 µm.

The thickness of the titanium nitride layer makes, on the average, 0.05-3.00 µm, thus the titanium nitride grains have the sizes, on the average, 0.01-1.00 µm, and the bulges and hollows on the grains have the height, on the average, of 0,005-0,5 µm. Such structure on the base surface can be manufactured by consistently forming on the surface a titanium porous layer at first, and then covering the layer by a titanium nitride layer. The titanium porous layer on an aluminium film can be manufactured by means of a titanium electron beam evaporation from a vaporizer and the subsequent condensation of the vapour flow on the film which continuously moved above the vaporizer at the distance 300 to 700 mm, at the angle of incidence of the vapour stream on the film of 50±10°, speed of condensation of the titanium vapour flow on the film of 0.1-1.0 µm/sec, the vacuum chamber pressure of 0.01-0.50 Pa and the condensation temperature of 300-550 °C. The titanium nitride layer can be formed on the titanium porous layer surface by a method of titanium electron beam evaporation in a nitrogen or ammonia atmosphere under pressure of 0.01-0,50 Pa and subsequent condensation on the titanium porous layer while the base is continuously moved above the vaporizer. It can be formed also by the method of titanium target cathode sputtering (by electric arcing, plasma arcing, ion-plasma and other) in a nitrogen or ammonia atmosphere under pressure of 0.01-1.00 Pa and subsequent condensation on the titanium layer while the base is continuously moved near the titanium target.

The invention also relates to the device of claim 3.

Essence of the invention will be clarified by drawings, where:
Fig.1 ia a cross section of a titanium porous layer on an aluminium film (a base);
Fig.2 is a cross section of one of the crystals in Fig.1;
Fig.3 is a cross section of a titanium porous layer with a titanium nitride porous layer deposited on it;
Fig.4 is a cross section of one of the crystals from Fig.3 with the deposited titanium nitride layer in the form of grains;
Fig.5 shows a microphotograph of the cathode film surface; and
Fig.6 shows a microphotograph of the cathode film cross section.

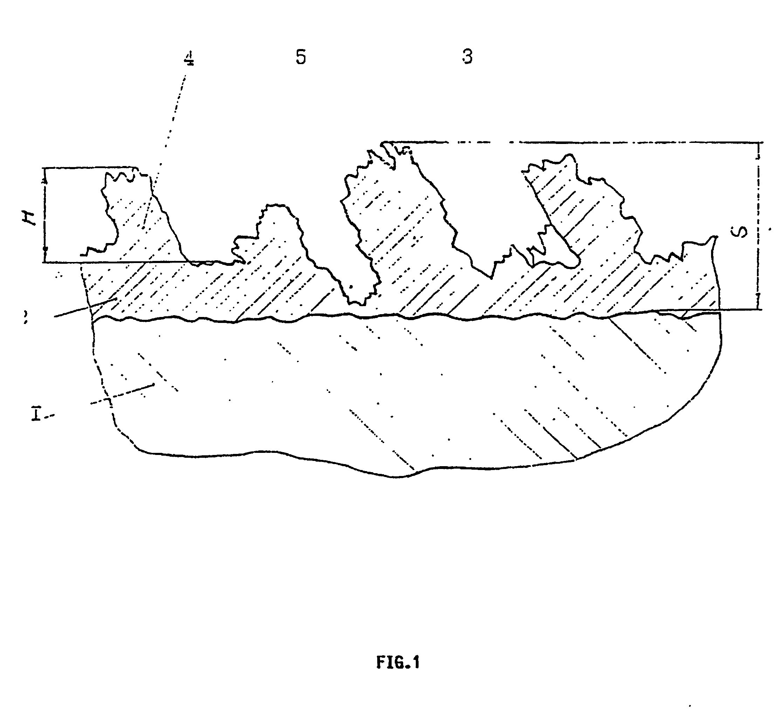

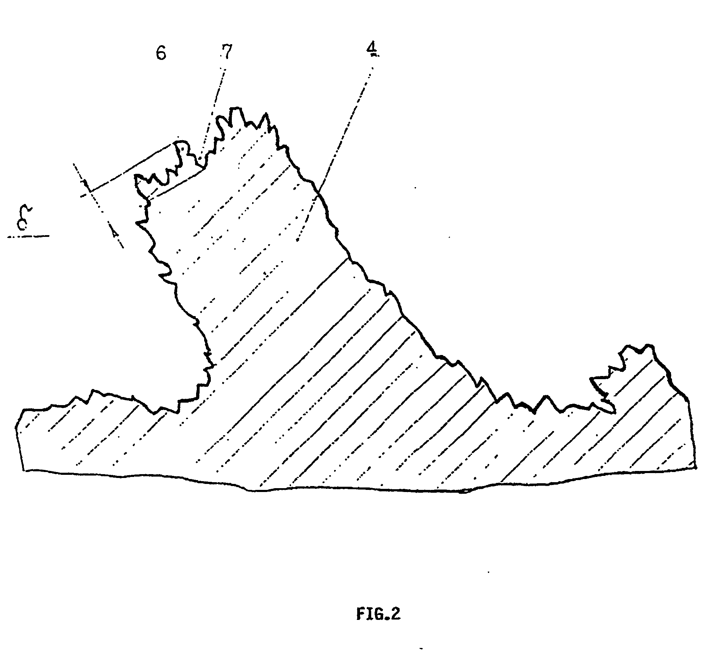

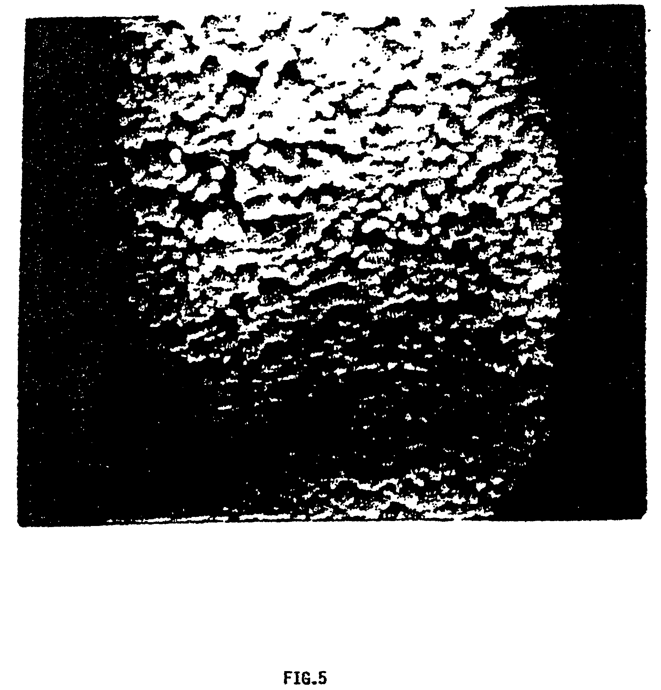

The cathode film contains an aluminium film (a base) 1 with a titanium porous layer 2 deposited on it (see Fig.1). The aluminium film of a purity not less than 98 % of Al shall be used as the base 1 for cathode film manufacture. Thickness of the base 1 makes 10-30 µm. Use of the film of thickness less than 10 µm is limited by its mechanical strength, and use of the film of thickness more than 30 µm is economically unadvisable. The titanium porous layer 2 includes crystalline grains 3 and crystalline blocks (see Fig.1 and Fig.5), having dendrite (columnar) structure which is shown in Fig.2; they are extended predominantly in the direction to a vaporizer. The dendrite height H should not exceed 2 µm, because the crystalline will be spilled at the largest height. Crystalline grains 3 and crystalline blocks 4 are separated by.pores 5 in the form of branched channels network (see Fig.5). Thus, part of the pores, naturally, are the closed ones; they are formed due to a shadow effect. However the most part of pores 5 of titanium porous layer 2 has predominantly opened outward exits. The thickness of titanium porous layer 5 makes, on the average, 0.5-5 µm. A coating on the aluminium film will not be continuous, if its thickness is less than 0.5 µm. The titanium layer will be split under influence of internal stresses (the recommended coating thickness is not higher than 15 % of the substrata thickness) or under influence of bending stresses at a film rewind, if the coating thickness is higher than 5 µm. Besides the closed porosity increases sharply, and the opened porosity decreases.

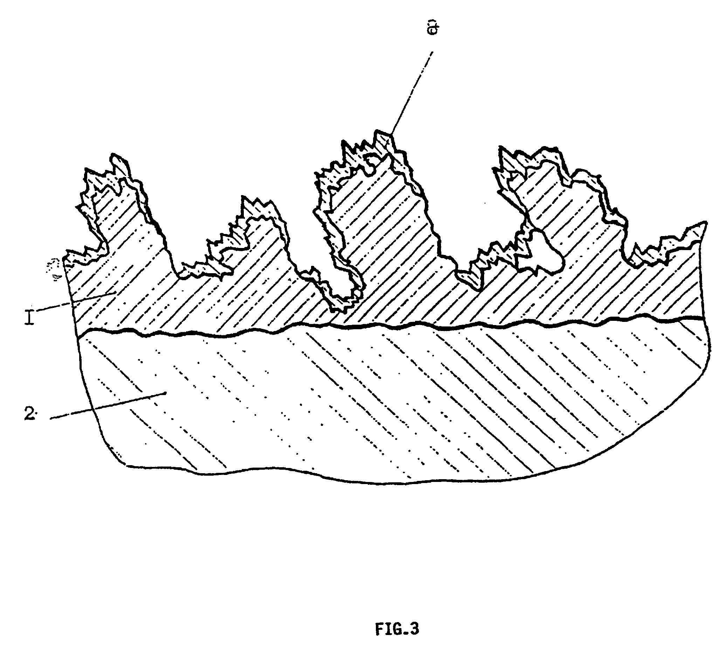

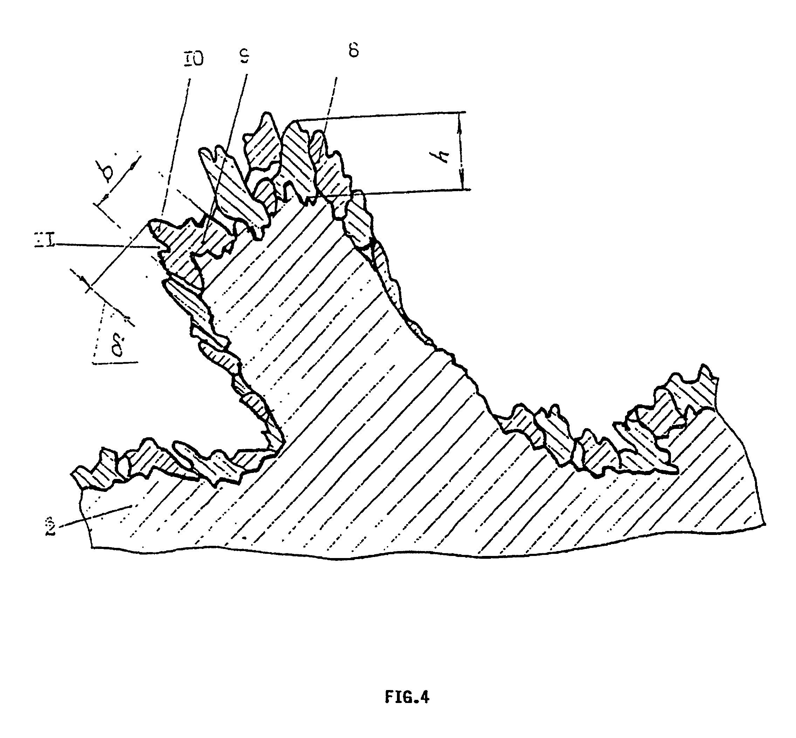

The surface of crystalline grains 3 and crystalline blocks 4, as well as internal surface of pores 5 is covered by bulges 6 and hollows 7 (see Fig.2). These bulges and hollows will form a honeycombed structure in the surface of titanium layer 2, increasing the total porosity. The height of bulges 6 and hollows 7 of the titanium layer 2 determines the height of bulges 10 and hollows 11 of the titanium nitride layer 8 (see Fig.3 and Fig.4), and consequently the porosity of the titanium nitride layer 8. The porosity of the titanium nitride layer 8 decreases if the height of bulges 6 and hollows 7 will be less than 0,01 mkm. and the porosity increases only slightly, if the height will be more than 1 mkm. The recommended height of bulges and hollows in the crystalline grains and crystalline blocks of the titanium porous layer lies in the range of 0.01-1 µm.

The total porosity of the titanium layer makes 25-30 per cent, and the pores are predominantly opened, that is a condition of manufacture of the titanium nitride porous layer. Titanium evaporates well, it has excellent adhesion properties, it is corrosion and thermal resistant, it is compatible with the aluminium as to the electrochemical potential. However the titanium high specific electrical resistance, its easy oxidation at evaporation accompanied by the formation of a number of non- equilibrum oxides, requires the deposition onto the titanium porous layer of additional coating.

A titanium porous layer on an aluminium film (a base) is formed by the titanium vacuum electron beam evaporation method from a vaporizer (the method of water-cooled crucible) and the subsequent condensation of a vapour stream on the film, while the base is continuously moved above the vaporizer. The condensation temperature equal to 0.2-0.5 of the evaporated material melting point and the vacuum chamber pressure of not below 0.01 Pa is recommended for the columnar structure with maximum opened porosity manufacture. The higher condensation temperature, the thicker and more aggregated dendrites. The higher pressure, the less aggregated dendrites and the less coating density. Therefore, the titanium condensation temperature in the range of 300-500 °C, the pressure of 0.01-0.50 Pa, the condensation speed of 0.1-1.0 µm/sec at the angle of incidence of the titanium vapour stream on the film of 50±10° and the distance between the vaporizer and the substrata of 300 to 700 mm are recommended. A fine grained, sub-microporous titanium coating structure with predominantly filed in porosity is formed on the substrata, if the condensation temperature is below than 300 °C. If the temperature is higher than 550 °C, approaching to the aluminium base melting point, the film loses the metal strength. If the chamber pressure is below 0.01 Pa, the condensation temperature will grow and the coating structure will change. If 'the chamber pressure is higher than 0.5 Pa, the condensation speed will reduce essentially and the porosity will decrease. At the condensation speed less than 0.1 µm/sec, productivity of the coating application is insufficient, while the realization of titanium condensation speed on the aluminium film which is higher than 1.0 µm/sec is technically difficult. If the angle of incidence of the titanium vapour stream on the base is less than 40° and more than 70°, the cover porosity decreases. At the distance between the vaporizer and the substrata less than 300 mm the film will overheat, and more than 500 mm the efficiency of process will decrease.

The titanium nitride layer 8 is deposited on the titanium porous layer 2 (see Fig.3). The titanium nitride layer 8 is composed from leaky aggregated grains 9 (see Fig.4) of size b which is, on the average, 0.01-1 µm. The titanium nitride layer thickness h makes, on the average, 0.05-3 µm. If the titanium nitride layer thickness is less than 0.05 µm, and size of the grains is less than 0.01 µm, it will be difficult to obtain the coating continuity. If the thickness of the layer is more than 3 µm or the titanium nitride grains size is more than 1 µm, the cover porosity will decrease and the strength properties are worsened. There are bulges 10 and hollows 11 on grains 9 of titanium nitride layer 8, average in height of 0.05-0.5 µm, which increase an actual surface of the cathode film. If the size of bulges and hollows is less than 0.005 µm, the wetting conditions of the surface by an electrolyte are worsened. If the bulges height is more than 0.5 µm, the bulges peaks will spoil and the coating will discontinue.

A titanium nitride layer on a titanium porous layer surface can be formed by methods of thin film vacuum application, namely, by deposition methods or sputtering methods. In the first case the formation of the titanium nitride film occurs in the process of titanium evaporation and subsequent condensation from the vapour phase on a continuously moving aluminium film having titanium porous layer, at a nitrogen or ammonia leakage. Thus nitrogen is restrictively dissolved in titanium; it forms a system characterized by peritectick reaction and the titanium nitride second phase. If the nitrogen or ammonia pressure is less than 0.01 Pa, the titanium nitride will be non- stoichiometric because of the small nitrogen concentration, and consequently it will be unstable; if the pressure is higher than 0.5 Pa, the speed of the layer deposition will be essentially reduced and the porosity will decrease.

The other recommended variant of titanium nitride film formation on a titanium porous layer of an aluminium film consists in a cathode sputtering of a titanium target in the nitrogen or ammonia atmosphere under the pressure of 0.01-1.0 Pa with deposition on the base which is continuously moved near the titanium target. As a particular method of the cathode sputtering, the electric arcing, plasma arcing, or ion-plasma methods are recommended.

If, at the titanium nitride layer deposition, the pressure of nitrogen or ammonia is below or higher than the recommended range, the inter-electrode gas will be ionized weakly and the sputtering process can be broken down.

The use of the titanium nitride as a working layer of an electrolytic condenser cathode film is stipulated first of all by the good electro- and physical properties of the titanium nitride thin layers. The titanium nitride, being deposited on the titanium porous underlayer of the aluminium base, is characterized by the developed surface, good electrical and thermal conductivity, heat stability, excellent corrosion stability in electrolytes used in condensers, and by high adhesion to a substrata.

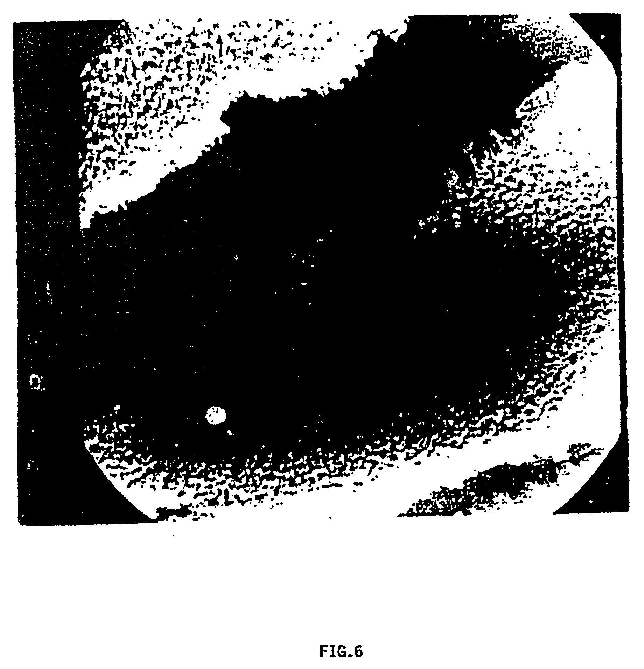

As a result, the specific cathode film capacity reaches the value of 2000-3000 mkF/cm², when titanium nitride is deposited on both sides of the aluminium film. The microphotograph of a surface and section of such film are presented in Fig.5 and Fig.6.

Particular modes of implementation of the invention follows:

### Example 1

The titanium porous layer was deposited by the method of titanium electron beam evaporation in a vacuum chamber from a water cooled copper crucible (vaporizer) on an aluminium film (a base) of 20 µm thickness and of 99.7 per cent purity, and subsequent condensation of the vapour stream on the base both sides. Thus the film was continuously moved above the vaporizer with the speed of 8.5 m/min, rewinding from one roll to the other in such a manner that the angle of incidence of the titanium vapour stream on the film had the value of 40-70°, and the distance to the vaporizer of 300 to 700 mm. The vacuum chamber pressure was maintained on the level of 0.5 Pa. The condensation speed was - of 300 °C.

The titanium porous layer deposited on both sides of the aluminium film in the afore mentioned manufacture conditions has the thickness of 0.5 µm. It includes crystalline grains and crystalline blocks in the form of dendrites with average height of 0.3 µm and bulges and hollows on the dendrites with average height of 0.1 µm, and pores in a form of channels, bordering dendrites and having predominantly opened outward exits. The total porosity of the layer has made 25 per cent.

Then, a titanium nitride layer was deposited in the vacuum chamber on the aluminium film covered on both sides by the porous titanium by the method of titanium target sputtering in the nitrogen atmosphere under the pressure of 0.01 Pa and subsequent sedimentation on the titanium porous layer surface. The aluminium film is continuously moved near the titanium target at the distance of 100 mm with the speed of 0.2 M/min.

Two targets were used for deposition of titanium nitride on both sides of the film. As a result, the titanium nitride layer (on both sides of the film) was obtained, having the thickness of 0.05 µm, average size of leaky aggregated grains of 0.01 µm, and bulges and hollows on them in height, on the average, of 0.005 µm.

### Example 2

A titanium porous layer was deposited by the titanium electron beam evaporation method in a vacuum chamber from a water cooled copper crucible (a vaporizer) on an aluminium film (a base) of 30 µm thickness and of 99.3 per cent purity, and subsequent condensation of a vapour stream on the base both sides. Thus the film was continuously moved above the vaporizer with the speed of 7.0 m/min, rewinding from one roll to the other in such a manner that the angle of incidence of the titanium vapour stream on the film had the value of 40-70°, and the distance to the vaporizer - of 300 to 700 mm. The vacuum chamber pressure was maintained on the level of 0.15 Pa. The condensation speed was of 0.45 µm/sec, and the condensation temperature - of 420 °C. The titanium porous layer deposited on both sides of the aluminium film in the afore mentioned manufacture conditions has the thickness of 3.0 µm. It includes crystalline grains and crystalline blocks in the form of dendrites with average height of 1.8 µm and bulges and hollows on the dendrites with average height of 0.3 µm, and pores in a form of channels, bordering dendrites and having predominantly opened outward exits. The total porosity of the layer has made 50 per cent. Then, a titanium nitride layer was deposited in the vacuum chamber on the aluminium film coated on both sides by the porous titanium by a method of titanium electron beam evaporation in the ammonia atmosphere under a pressure of 0.15 Pa and subsequent condensation on the titanium porous layer surface. The aluminium film is continuously moved above the vaporizer with a speed of 7.0 M/min.

As a result, the titanium nitride layer (on both sides of the film) was obtained, having the thickness of 2.0 µm, average size of leaky aggregated grains of 0.5 µm, and bulges and hollows on them in height, on the average, of 0.15 µm.

### Example 3

A titanium porous layer was deposited by the titanium electron beam evaporation method in a vacuum chamber from a water cooled copper crucible (a vaporizer) on an aluminium film (a base) of 30 µm thickness and of 98.0 per cent purity, and subsequent condensation of the vapour stream on the base both sides. Thus the film was continuously moved above the vaporizer with a speed of 8.5 m/min, rewinding from one roll to the other in such a manner that the angle of incidence of the titanium vapour stream on the film had the value of 50±10°, and the distance to the vaporizer - of 300 to 700 mm. The vacuum chamber pressure was maintained on the level of 0.01 Pa. The condensation speed was of 1.0 µm/sec, and the condensation temperature - of 530 °C.

The titanium porous layer deposited on both sides of the aluminium film in the afore mentioned manufacturing conditions has the thickness of 5.0 µm. It includes crystalline grains and crystalline blocks in the form of dendrites with average height of 2.0 µm and bulges and hollows on the dendrites with average height of 1.0 µm, and pores in a form of channels, bordering dendrites and having predominantly opened outward exits. The total porosity of the layer has made 37 per cent.

Then, a titanium nitride layer was deposited in the vacuum chamber on the aluminium film covered on both sides by the porous titanium by the plasma arcing method of titanium target sputtering in the nitrogen atmosphere under the pressure of 1 Pa and subsequent condensation on the titanium porous layer surface. The aluminium film is continuously moved near the titanium target at a distance of 50 mm with a speed of 0.5 m/min. Two targets were used for deposition of titanium nitride on both sides of the film.

As a result, the titanium nitride layer (on both sides of the film) was obtained, having the thickness of 3.0 µm, average size of leaky aggregated grains of 1.0 µm, and bulges and hollows on them in height, on the average, of 0.5 µm.

Capacity of cathode film samples manufactured as in examples 1 to 3 was measured in 10 per cent solution of ammonium adipate having the specific resistance of 15 ohm/cm at the temperature of 30 °C and the frequency of 100 Hz. Results of the measurements in comparison with analogue are given in the following table.

For determination of specific capacity stability the cathode film was tested on hydration by boiling in the deionized water during 6 hours.

The use of the cathode film and the method of its preparation in the electrolytic condenser manufacture will allow to reduce consumption of a cathode and anode, a condenser paper, to diminish dimensions and weight of condensers, to increase their specific electrical characteristics.

| No. | Method of manufacture | Film thickness (µm) | Specific capacity µF/cm² |
|---|---|---|---|
| 1 | Example 1 | 20 | 1300 |
| 2 | Example 2 | 30 | 2600 |
| 3 | Example 3 | 30 | 1900 |
| 4 | European patent application No.0272926 | 40 | 1250 |

A device, serving for the porous coating increase, contains a vaporizer, guide (the upper and lover) rollers, and deflecting rollers which are manufactured in the form of cooled cylinders and located above the vaporizer in such a way that the strip bending around the rollers forms a polygonal line having sections (sites of applying) between the guide rollers. The film sections between the upper guide rollers are located over the vaporizer in such a way that a straight line connecting the vaporizer centre and any point of any of these sections makes an angle of 40-60° with the normal to the given section in this point. The film sections between the lower guide rollers are located above the vaporizer in such a way that a straight line connecting the vaporizer centre and any point of any of these sections makes an angle of 0-10° with the normal to the given section in this point. The lower guide rollers are provided by a herringbone-like grooves on the cylindrical surface of the rollers.

Layout of the rollers provides for a technical result - an increase of the porous film cover surface can be achieved thanks to formation of columnar structure having the maximally opened porosity and good adhesion of the coating to the film. The rollers are manufactured in the form of cooled cylinders and located above the vaporizer in such a way that the strip moves along a particular polygonal trajectory. Thus the angle of condensation of the metal vapour stream from the vaporizer makes 0-10°. In these conditions the condensation temperature makes more than 0.5 of the evaporated material melting point, processes of thermal activation and chemical interaction between atoms of cover and substrata are active on the film, and the strong chemical connections are established between the atoms, that provides good adhesion of the cover to the film. A thin adhesion underlayer is deposited on these sections of the film. The film sections between the upper guide rollers are located in such a way that the vapour stream is condensed on the adhesion underlayer under the sharp angle of 40-60°. The condensation temperature makes 0.25-0.5 of the evaporated material melting point, that in a combination to inclined condensation provides for the manufacture of highly porous layer of a columnar structure of elongated crystalline (dendrites), surrounded by pores in the form of branched channels network with predominantly opened outward exits. A highly porous cover layer can be subsequently manufactured on these sections having the required thickness and the maximum surface area.

A layout of the lower guide rollers located above the vaporizer in the zone of direct condensation of the metal vapour stream on the strip prevents the creases formation on the wide strip. The manufacture of these rollers with the herringbone-like grooves on the cylindrical surface permits to flatten the strip from a middle to edges for the account of the strip tension force component occurring at a rewind of the strip and directed from the centre to the periphery of the herringbone-like grooves.

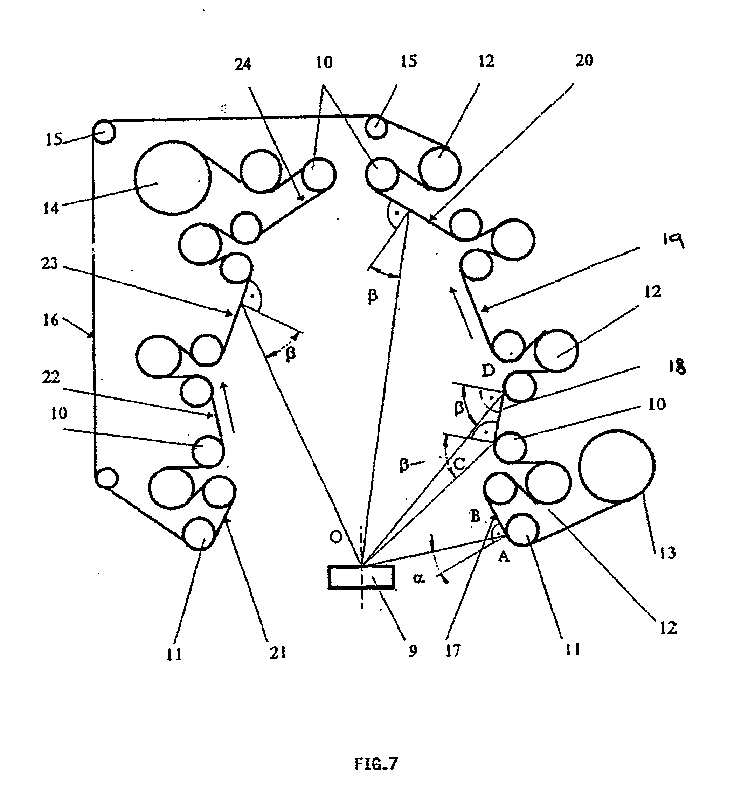

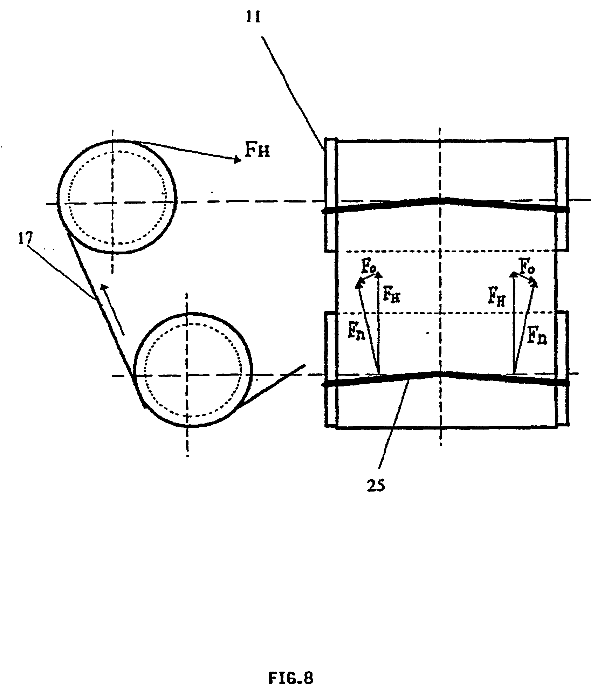

Work of the device will be clarified with references to Fig.7 and Fig.8.

A diagram of a device for both sides application of porous coating on a continuously moved strip is shown in Fig.7. Two lower rollers with herringbone-like grooves on the cylindrical surfaces are shown in two projections in Fig.8.

The device (see Fig.7) contains a vacuum chamber (not shown on the diagram), a vaporizer 9, upper guide rollers 10,lower guide rollers 11, deflecting rollers 12, a reel-out shaft 13, a reel-up shaft 14 and rollers 15. The guide rollers 10, 11 and deflecting rollers 12 are made in the form of cooled cylinders and are installed above the vaporizer 9. The strip 17, bending around the guide rollers 10, 11 and deflecting rollers 12, forms a polygonal line, including strip sections 17, 18, 19, 20 and sections 21, 22, 23 and 24; last sections are symmetric to the first in respect of the vertical axis of the vaporizer 9. Thus the straight line from the vaporizer 9 centre to any point of sections 17 and 20, makes an angle with the normal in this point of the respective section of α = 0-10°. In particular, the angle α between the straight line OA and the normal to the section AB in the point A makes α = 10°. The straight line from the vaporizer 9 centre to any point of sections 18, 19, 20, 22, 23 and 24, makes an angle with the normal in this point of the respective section of β = 40-60°. So, the angle between the straight line OC and the normal in point C of the section CD makes β = 40°, and the angle between the straight line OD and the normal in point D of the section CD makes β = 60°. The lower guide rollers 11, forming sections 17 and 21, are provided by herringbone-like grooves 25 on the cylindrical surface (see Fig.8). The section of the strip 16 bends around section 17 between rollers 11. The strip tension force F_{H} acts on the strip 16 at the section 17 at a rewind of the strip 16. The force F_{H} has the normal Fₙ component and the axial Fₒ component directed along the herringbone-like grooves.

The device works as follows.

The vaporizer 9, located in the vacuum chamber (not shown on the diagram) of the device (see Fig 7), generates, under the influence of heating (for example, by the electron beam heating), the metal vapour stream, extending on the all hemisphere over the vaporizer 9. The strip 16 is continuously rewound from the reel-out shaft 13 through the lower guide rollers 11, the upper guide rollers 10 with the deflecting rollers 12, and the rollers 15 to the reel-up shaft 14. The cold strip 16 arrives from the reel-out shaft 13 to the deposition zone at section 17 between the cooled rollers 11. The metal vapour from the vaporized 9 is condensed at section 17 under the condensation angle of 0° to 10°; that permits to receive an adhesion underlayer on the strip. Thus, due to the herringbone-like grooves 25 on the cylindrical surfaces of the lower guide rollers 11, the strip 16 is flattened from a middle to edges by Fₒ component of the strip tension force F_{H} (see Fig.8). Then the strip 16 is cooled on the roller 12 and arrives to the deposition zone on sections 18, 19, 20, where a vapour from the vaporizer 9 is condensed under the condensation angle of 40° to 60°. The highly strong layer of the coating is sequentially deposited at these sections with intermediate cooling of the strip 16 on rollers 12 which prevents an overheating. Further, the strip 16 arrives through the rollers 15 to the zone of coating deposition on the other side of the strip 16. A trajectory of the strip 16 movement in this zone and the sequence of layers applying are analogous to ones described afore. After the cooling on the roller 12 the strip 16 is reeled up on the reel-up shaft 14.

## Claims

1. A method of cathode film manufacture, including a step of applying a titanium porous layer on an aluminium film by a vacuum deposition,
**characterized in that**
the deposition is provided by means of a titanium electron beam evaporation
at a continuous movement of the aluminium film above a vaporizer at a distance of 300 to 700 mm and an angle of incidence of the vapour stream on the film of 50 ± 10°,
at a vacuum chamber pressure of 0.01 to 0.5 Pa,
at a condensation temperature of 300 to 550°C,
after that a titanium nitride layer is formed by means of a titanium evaporation in the nitrogen or ammonia atmosphere at a pressure of 0.01 to 0.5 Pa.

2. A method of cathode film manufacture, including a step of applying a titanium porous layer on an aluminium film by a vacuum deposition,
**characterized in that**
the deposition is provided by means of a titanium electron beam evaporation
at a continuous movement of the aluminium film above a vaporizer at a distance of 300 to 700 mm and an angle of incidence of the vapour stream on the film of 50 ± 10°,
at a vacuum chamber pressure of 0.01 to 0.5 Pa,
at a condensation temperature of 300 to 550°C,
after that a titanium nitride layer is formed by means of a cathode sputtering of a titanium target in the nitrogen or ammonia atmosphere at a pressure of 0.01 to 1.0 Pa.

3. A device for porous surfaces application on a strip containing a vacuum chamber, a vaporizer, upper und lower guide and deflecting rollers for transportation of the strip, the guide and deflecting rollers being made in the form of cooled cylinders and installed above the vaporizer in such a way that the strip bending around the rollers forms a polygonal line comprising strip sections between the guide rollers,
**characterized in that**
the strip sections between the upper guide rollers are located above the vaporizer In such a way that the straight line from the vaporizer centre to any point of any of these sections makes an angle with the normal in this point of 40 to 60°, and
the strip sections between the lower guide rollers are located above the vaporizer in such a way that the straight line connecting the vaporizer centre with any point of any of these sections makes an angle with the normal in this point of the section of 0 to 10°.

4. The device according to claim 3,
**characterized in that**
the lower guide rollers are provided by herringbone-like grooves on the rollers cylindrical surface.

5. A cathode film of an electrolytic condenser, containing a titanium porous layer on an aluminium base with a titanium nitride layer deposited on it,
**characterized in that**
titanium porous layer thickness makes 0.5 to 5.0 µm, bulges and hollows on crystalline grains and crystalline blocks of the titanium porous layer make 0.01 to 1.0 µm, and the total porosity makes 25 to 50 per cent,
while the titanium nitride layer makes 0.05 to 3.0 µm, titanium nitride grains make 0.01 to 1.0 µm, and the height of bulges and hollows on the titanium nitride grains makes 0.005 to 0.5 µm.

## Patentansprüche

1. Herstellungsverfahren für eine Kathodenschicht, das einen Schritt umfasst, eine poröse Titanschicht durch Vakuumbeschichten auf eine Aluminiumschicht aufzubringen,
**dadurch gekennzeichnet, dass**
das Beschichten mittels einer Titanelektronenstrahlverdampfung bei einer kontinuierlichen Bewegung der Aluminiumschicht über einem Verdampfer mit einem Abstand von 300 bis 700 mm und einem Einfallwinkel des Dampfstroms auf die Schicht von 50 ± 10° bei einem Vakuumkammerdruck von 0,01 bis 0,5 Pa,
bei einer Kondensationstemperatur von 300 bis 550°C stattfindet,
wonach sich eine Titannitridschicht mittels einer Titanverdampfung in der Stickstoff- oder Ammoniakatmosphäre bei einem Druck von 0,01 bis 0,5 Pa bildet.

2. Herstellungsverfahren für eine Kathodenschicht, das einen Schritt umfasst, eine poröse Titanschicht durch Vakuumbeschichten auf eine Aluminiumschicht aufzubringen,
**dadurch gekennzeichnet, dass**
das Beschichten mittels einer Titanelektronenstrahlverdampfung bei einer kontinuierlichen Bewegung der Aluminiumschicht über einem Verdampfer mit einem Abstand von 300 bis 700 mm und einem Einfallwinkel des Dampfstroms auf die Schicht von 50 ± 10° bei einem Vakuumkammerdruck von 0,01 bis 0,5 Pa,
bei einer Kondensationstemperatur von 300 bis 550°C stattfindet,
wonach sich eine Titannitridschicht mittels einer Kathodenzerstäubung eines Titantargets in der Stickstoff- oder Ammoniakatmosphäre bei einem Druck von 0,01 bis 1,0 Pa bildet.

3. Vorrichtung zum Aufbringen poröser Oberflächen auf einen Streifen, die eine Vakuumkammer, einen Verdampfer, obere und untere Führungs- und Ablenkwalzen zur Beförderung des Streifens umfasst, wobei die Führungs- und Ablenkwalzen in Form von gekühlten Zylindern hergestellt und über dem Verdampfer so angebracht sind, dass der Streifen, der sich um die Walzen krümmt, eine polygonale Linie bildet, die Streifenabschnitte zwischen den Führungswalzen umfasst,
**dadurch gekennzeichnet, dass**
die Streifenabschnitte zwischen den oberen Führungswalzen so über dem Verdampfer angeordnet sind, dass die gerade Linie von der Verdampfermitte zu jedem Punkt jedes dieser Abschnitte an diesem Punkt einen Winkel mit der Senkrechten von 40 bis 60° bildet, und
die Streifenabschnitte der unteren Führungswalzen so über dem Verdampfer angeordnet sind, dass die gerade Linie, die die Verdampfermitte mit jedem Punkt jedes dieser Abschnitte verbindet, an diesem Punkt des Abschnitts einen Winkel mit der Senkrechten von 0 bis 10° bildet.

4. Vorrichtung nach Anspruch 3,
**dadurch gekennzeichnet, dass**
die unteren Führungsrollen mit fischgrätartigen Rillen auf der zylindrischen Walzenoberfläche versehen sind.

5. Kathodenschicht eines Elektrolytkondensators, die eine poröse Titanschicht auf einer Aluminiumunterlage mit einer darauf aufgebrachten Titannitridschicht umfasst,
**dadurch gekennzeichnet, dass**
die Dicke der porösen Titanschicht 0,5 bis 5,0 µm beträgt, Erhebungen und Vertiefungen auf den Kristallkörnern und Kristallblöcken der porösen Titanschicht 0,01 bis 1,0 µm betragen, und die Gesamtporosität 25 bis 50 % beträgt,
während die Titannitridschicht 0,05 bis 3,0 µm beträgt, die Titannitridkörner 0,01 bis 1,0 µm betragen, und die Höhe der Erhebungen und Vertiefungen auf den Titannitridkörnern 0,005 bis 0,5 µm beträgt.

## Revendications

1. Procédé pour la fabrication d'un film de cathode, incluant une opération consistant à appliquer une couche poreuse de titane sur un film d'aluminium par déposition sous vide, **caractérisé en ce que** :
la déposition est assurée au moyen de l'évaporation du titane sous un faisceau d'électrons,
avec un mouvement continu du film d'aluminium au-dessus d'un évaporateur à distance de 300 à 700 mm et sous un angle d'incidence du flux de vapeur sur le film de 50 ± 10 degrés,
sous une pression de 0,01 à 0,5 Pa dans la chambre à vide,
sous une température de condensation de 300 à 550 °C,
après quoi une couche de nitrure de titane est formée au moyen d'une évaporation de titane dans une atmosphère d'azote ou d'ammoniac sous une pression de 0,01 à 0,5 Pa.

2. Procédé pour la fabrication d'un film de cathode, incluant une opération consistant à appliquer une couche poreuse de titane sur un film d'aluminium par déposition sous vide, **caractérisé en ce que** :
la déposition est assurée au moyen de l'évaporation du titane sous un faisceau d'électrons,
avec un mouvement continu du film d'aluminium au-dessus d'un évaporateur à distance de 300 à 700 mm et sous un angle d'incidence du flux de vapeur sur le film de 50 ± 10 degrés,
sous une pression de 0,01 à 0,5 P a dans la chambre avide,
sous une température de condensation de 300 à 550 °C,
après quoi une couche de nitrure de titane est formée au moyen d'une pulvérisation cathodique d'une cible en titane dans une atmosphère d'azote ou d'ammoniac sous une pression de 0,01 à 1,0 Pa.

3. Appareil pour l'application de surfaces poreuses sur une bande, comprenant une chambre à vide, un évaporateur, un guide supérieur et un guide inférieur, et des rouleaux de déflexion pour le transport de la bande, le guide et les rouleaux de déflexion étant réalisés sous la forme de cylindres refroidis et installés au-dessus de l'évaporateur de telle manière que la flexion de la bande autour des rouleaux forme une ligne polygonale comprenant des sections de bande entre les rouleaux de guidage,
**caractérisé en ce que**
les sections de bande entre les rouleaux de guidage supérieurs sont situées au-dessus de l'évaporateur de telle manière que la ligne droite depuis le centre de l'évaporateur jusqu'à un point quelconque de l'une quelconque de ces sections fait avec la normale à ce point un angle de 40 à 60 degrés, et
les sections de bande entre les rouleaux de guidage inférieurs sont situées au-dessus de l'évaporateur de telle manière que la ligne droite qui connecte le centre de l'évaporateur avec un point quelconque de l'une quelconque de ces sections fait avec la normale à ce point de la section un angle de 0 à 10 degrés.

4. Appareil selon la revendication 3, **caractérisé en ce que**
les rouleaux de guidage inférieurs sont pourvus de gorges disposées à la manière d'arêtes de poisson sur la surface cylindrique des rouleaux.

5. Film de cathode d'un condensateur électrolytique, contenant une couche poreuse de titane sur une base d'aluminium avec une couche de nitrure de titane déposée sur celle-ci, **caractérisé en ce que**
l'épaisseur de la couche poreuse de titane s'élève de 0,5 à 5,0 microns, les bosses et les creux sur les grains cristallins et les blocs cristallins de la couche poreuse de titane s'élèvent de 0,01 à 1,0 microns, et la porosité totale représente de 25 à 50 %,
la couche de nitrure de titane est de 0,05 à 3,0 microns, les grains de nitrure de titane s'élèvent de 0,01 à 1,0 microns, et la hauteur des bosses et des creux sur les grains de nitrure de titane s'élèvent de 0,005 à 0,5 microns.
